# EUROPEAN PATENT APPLICATION

(11) **EP 0 849 782 A1**
(43) Date of publication of application: **24.06.1998**
(21) Application number: 97122252.6
(22) Date of filing: 17.12.1997
(51) Int. Cl.: H01L 21/336, H01L 29/78

(54) **A mos transistor**

(30) Priority: 20.12.1996 US 770968
(71) Applicant: SIEMENS AKTIENGESELLSCHAFT, 80333 München (DE)
(72) Inventor: Arnold, Norbert, New Hampstead, NY 10977 (US)
(74) Representative: Patentanwälte Westphal, Buchner, Mussgnug Neunert, Göhring

(57) **Abstract**

An MOS transistor utilizes a shallow isolation trench filled with a silicon oxide to define an active area. Doped polysilicon layers supported in part on the filled trench overlap portions of the active area. These doped layers are used as a source of ions to form diffused source and drain regions in the active area. A doped polysilicon layer extends over the active surface area between sidewall spacers on the edges of the source and drain contact layers to form the gate and gate contact of the transistor.

## Description

### Field of the Invention

This invention relates to Metal-Oxide-Semiconductor (MOS) field effect transistors, and more particularly, to transistors adapted for use in high density integrated circuits.

### Background of the Invention

Conventional MOS transistors now are generally made in a semiconductor body by a self-aligned gate process in which the gate is formed first. The gate is the electrode that controls the flow of charge carriers in the channel between the source and drain (also denoted as current terminals). The gate is then used as a mask to define the source and drain regions, which typically are then formed by ion implantation or diffusion of appropriate dopants. As a result, it is assured that the edges of the implanted or diffused source and drain are essentially aligned with the edges of the gate. As the feature size of such transistors is reduced to meet demands for high density circuits, it has become increasingly difficult to provide the ohmic contacts required to such source and drain regions while maintaining adequate margins to avoid undesirable overlap of the channel and to insure electrical isolation from the gate contact.

From the above discussion, it is apparent that there is a need for a MOS transistor having source and drain regions that are easily formed without undesirable overlap of the channel.

### Summary of the Invention

The present invention is related to a transistor and the process for fabricating it.

In one embodiment, the invention comprises a field effect transistor having source and drain regions of like conductivity type spaced apart to form a channel therebetween at the surface of an active surface region in a semiconductor body, a gate electrode extending adjacent to the channel and spaced therefrom by a gate dielectric layer and source and drain contacts. The source and drain contacts were originally spaced portions of a continuous doped contact layer over the active surface region that had an intermediate portion removed to define the channel and that was of a composition that included dopants, some of which were made to diffuse out of the contact portions into the semiconductor body to form source and drain regions underlying the source and drain contacts, respectively.

In another embodiment, a field effect transistor is disclosed. The transistor comprises a semiconductor body including source and a drain regions of like conductivity type spaced apart in the body essentially to define therebetween a channel and a gate overlying the channel and spaced therefrom by the gate dielectric. A dielectric filled trench is included within the body and defines an active surface region of the body. Separate doped contact layers electrically contact the source and drain regions and are supported on the dielectric-filled trench such that each partially overlies the active surface region. The gate extends between the source and drain contacts and is electrically isolated from the source and drain regions by sidewall spacers; and the source and drain regions extend in the body underneath the respective contacts thereto and underneath the sidewall spacers.

In yet another embodiment of the invention, a field effect transistor having drain and source regions, a channel, a gate and a gate dielectric, and separate electrical contacts coupled to the drain, source, and gate is disclosed. The transistor comprises a silicon body and a dielectric-filled trench within the body and defining an active region of the body. The source and the drain regions are of the like conductivity type and are spaced apart within the active region of the body for defining the channel of the transistor. The gate dielectric layer is located over the channel. The electrical contacts coupled to the drain and source regions each are doped polysilicon, and are supported on the dielectric-filled trench such that each partially overlies the active region for contacting the source and the drain regions, respectively. There are sidewall spacers on the edges of the electrical contacts that overlie the active region of the body. The drain and source regions each extending in the active region from a sidewall of the dielectric-filled trench under the respective electrical contacts essentially to an edge of the respective sidewall spacer. The gate contact is in contact with the gate dielectric layer and is electrically isolated from the drain and source contacts by the sidewall spacers.

In an alternative embodiment, a process fabricating a field effect transistor is disclosed. The process comprises the steps of: providing a semiconductor body that comprises an active surface region in which the transistor is to be formed; depositing on a top surface of the active surface region a doped contact layer that can serve as a conductive contact to the active surface region and that includes dopants that can be diffused out to form source and drain regions in the active surface layer; removing an intermediate portion of the layer so as to form two separate source and drain contact portions that are spaced apart on the top surface of the active surface region by a distance suitable for a length of the channel of the transistor; providing dielectric spacers at least on the sidewall edges facing one another of the source and drain contact portions; forming a gate dielectric layer on the surface portion of the active surface region between the source and drain contact portions and their sidewall spacers; forming a gate over the gate dielectric layer; and diffusing dopants from the contact portions into the body for forming source and drain regions in the active surface region under the source and drain contact portions and their sidewall spacers.

Another embodiment of the invention comprises: forming in a monocrystalline silicon body a dielectric-filled trench to define an active surface region of the body; implanting ions in the active surface area of the body for establishing desired resistivity characteristics; forming over the body a polysilicon layer doped with atoms capable of forming source and drain regions at the surface the active surface region; etching the polysilicon layer to form a central opening for defining the channel of the transistor, leaving separate source and drain contact portions partially supported on the dielectric-filled trench and partially overlapping the active surface region; forming dielectric spacers on sidewalls of edges of the polysilicon layer portions overlapping the active surface region; forming a gate dielectric layer over the active surface area between said dielectric spacers; providing a gate over the gate dielectric layer; and heating the source and drain contact portions during processing to cause atoms from the doped polysilicon contact portions to diffuse into the silicon body underlying the contact portions and the sidewall spacers so as to form spaced drain and source regions in the body with the source contact portion being in electrical contact with the source region and the drain contact portion being in electrical contact with the drain region.

The invention will be better understood from the following drawings.

### Brief Description of the Drawings

FIGS. 1-5 show cross-sectional views of a silicon body in various stages of the process of forming therein an enhancement-mode transistor illustrative of the present invention; and
FIG. 6 shows a cross-sectional view of a depletion-mode transistor illustrative of the present invention.

It should be noted that the drawings are not to scale.

### Detailed Description

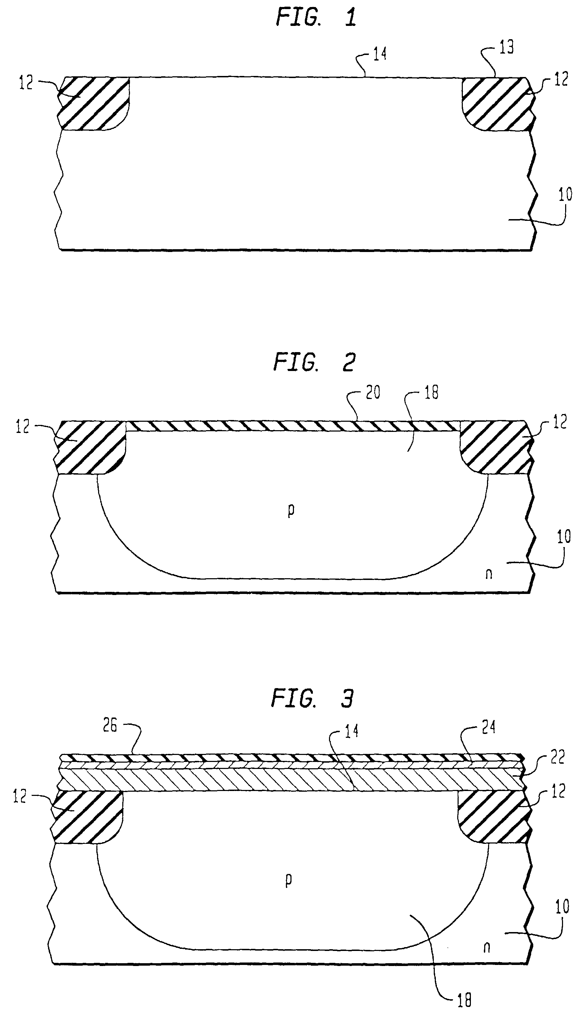

Referring now to FIG. 1, there is shown a cross-sectional view of a portion of a monocrystalline silicon (semiconductor) body 10 within which has been formed a dielectric-filled trench 12 that surrounds and defines an active surface region 14 at a top surface 13 of the silicon body 10.

Generally, the dielectric forming the trench fill 12 is a silicon oxide or a silicate glass, and the structure shown is advantageously formed by a process known as shallow trench isolation (STI). Basically this process involves masking a portion of the top surface 13 of the body 10 that is to form the active surface region 14, etching the exposed surface of the body around the active surface region 14 anisotropically to form a trench to the desired depth, depositing the dielectric-filled over the body at least to the depth of the trench, and then planarizing the top surface of the dielectric layered body by chemical mechanical polishing to achieve the structure shown in FIG. 1. Techniques for forming STIs are described in Davari et al., 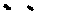 A new planarization technique using a combination of RIE and chemical-mechanical polish (CMP)'', IEDM Tech. Dig. (1989) and Fuse et al., 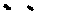 A practical trench isolation technology with a novel planarization process'', IEDM Tech. Dig. (1987), which are herein incorporated by reference for all purposes.

Typically, the silicon body has a top surface large enough to accommodate a large number of transistors of which some are to be of n-type and others to be of p-type so as to form complementary metal-oxide-semiconductor (C-MOS) circuits. Dielectric-filled trenches may be provided around individual or groups of transistors.

The silicon body 10 generally will be of relatively high resistivity, either p-type or n-type conductivity. Moreover, the silicon body 12 may be either part of a silicon wafer, as cut from an ingot, or an epitaxial layer that has been grown on a silicon or insulating (such as sapphire) substrate.

Moreover, it is the usual, although not essential, practice to form a well 18 of the desired resistivity characteristics that encompasses the active surface region 14 of the body 10 within which a transistor is to be formed. As shown, for use in a n-channel enhancement or depletion-mode transistor, the well 18 is of p-type conductivity and the bulk of the silicon body is n-type conductivity. In a p-channel enhancement or depletion-mode transistor, the well 18 would be of n-type conductivity. Both N and p-channel depletion-mode transistors include a thin surface layer in the well. In the n-channel depletion-mode transistor, the thin surface layer is n-type conductivity. As for the p-channel depletion mode transistor, the thin surface layer is of p-type conductivity.

Generally the well 18 is formed by ion implantation. Ion implantation is described in Sze, VLSI Technology, 2nd ed., NY, McGraw-Hill (1988), which is herein incorporated by reference for all purposes. Prior to ion implantation, there is customarily provided a sacrificial oxide over the silicon surface during the implantation to protect the silicon surface. After the ions are implanted, there generally follows an annealing cycle that helps drive the implanted ions deeper into lattice sites for activation.

In FIG. 2, there is shown an implanted well 18 of p-type conductivity for forming a n-channel enhancement-mode transistor and a sacrificial oxide surface layer 20.

Next, the oxide layer 20 is stripped away, typically by etching, and a doped layer 22 of polysilicon is deposited thereover in known fashion. For fabricating a n-channel enhancement-mode transistor, the layer 22 would be doped to include a donor diffusant, such as arsenic or phosphorus. If a p-type enhancement-mode transistor were to be formed, the well would have been n-type and an acceptor diffusant, such as boron, would have been included as the dopant in the polysilicon layer.

The polysilicon layer 22 advantageously extends over both the active surface area 14 and the dielectric-filled trench 12.

It is usually desirable to coat the polysilicon layer 22 with a layer 24 that is highly conductive, such as a tungsten or molybdenum refractory metal silicide. Layer 24 is in electrical contact with layer 22 and serves to provide a low resistance (high conductivity) path. It may be advantageous also to cover this silicide layer in turn with an anti-reflective dielectric coating (ARC) 26, such as a layer of silicon nitride or silicon oxide or a dual layer including a layer of each. The use of ARC improves the resolution of lithographic techniques. It may also be advantageous to provide, for protection during the remainder of processing, a dielectric cap (not shown) over the layers 22, 24, and 26 that have been formed.

For better control of the diffusion in the silicon body, one may choose initially to substitute the doped polysilicon contact layer 22 with a multilayer stack including an undoped polysilicon contact layer, a thin diffusion barrier layer, for example of titanium nitride, and a doped polysilicon layer, so that diffusion of dopants from the contact layer into the semiconductive body can be postponed until late in the processing when an appropriate heating step is used to diffuse into the silicon body the dopants from the doped polysilicon layer through both the barrier layer and the undoped polysilicon contact layer, thereby doping both the polysilicon contact layer and the underlying portion of the silicon body. In some cases, it may be possible to use the heating step that forms the gate oxide for the diffusion. As another alternative, the polysilicon contact layer 22 may be deposited initially as undoped and be ion-implanted appropriately at a later stage. This approach is particularly convenient for C-MOS circuits formed in a single body where the polysilicon contact portions needs to be doped appropriately for the type of transistor involved.

In addition, diffusing the dopants from the contact layer into the body later on in the process provides more flexibility in controlling the outdiffusion of the dopants from the contact layer to the region under the gate.

Alternatively, instead of a polysilicon contact layer, there can be employed a layer of a refractory metal silicide, such as tungsten or molybdenum silicide, that includes an impurity that can be diffused out in the course of the processing to dope the silicon body appropriately.

It will be convenient to describe each of these various alternatives generically simply as a doped contact layer.

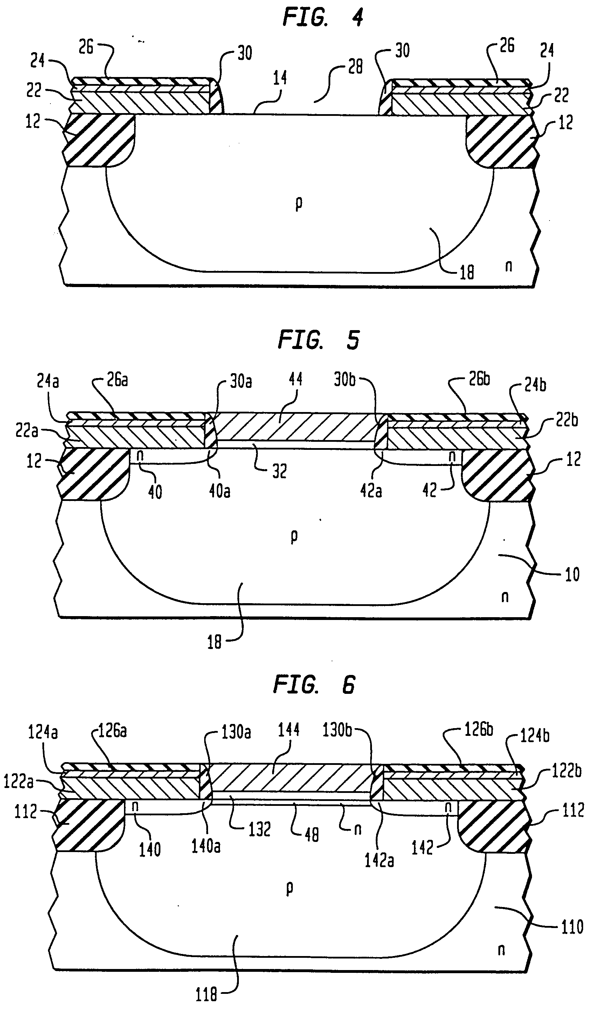

Next, as is shown in FIG. 4, a central portion of the layers 22, 24, and 26 overlying the well 18 is removed to form an opening 28 where the active surface region 14 is exposed. This is typically done by photolithographic masking and etching in known fashion. Layers to the left of the opening 28 are henceforth denoted with the original reference number and an "a" added to the end thereof. Layers to the right of the opening 28 are henceforth denoted with the original reference number and a "b" added to the end thereof. After the opening 28 has been formed, dielectric spacers 30a and 30b are provided along its edges. Before these are formed, it may be advantageous to passivate the sidewalls of the stack, as by a sidewall oxidation step, and to anneal or remove any damage caused by the reactive ion etching step used to form the opening 28. This sidewall oxidation also can be advantageous for providing an etch stop for the later etching of sidewall spacers 30a and 30b at least along the portions overlapping the active surface area 14. These processing steps can be done in conventional manner.

Next there is formed the gate oxide that serves as the gate dielectric. The gate lithography, for best results, is performed on a substantial planar surface over the whole silicon slice being processed. The following techniques can be used to achieve a substantially planar surface.

In one embodiment, the spacing between the individual transistors of the silicon wafer is adjusted so that there are no spaces remaining over the silicon wafer that are wider than twice the proposed gate conductor thickness. This should insure that the surface of the silicon wafer is sufficiently planar. Desirably, any fill used to achieve such spacing between adjacent transistors should be of the same composition as that used for the fill for the opening 28.

In another embodiment, the spaces between all of the stacks on the silicon wafer are filled after the sidewalls have been formed on the contact portions with a dielectric fill so as to overfill the spaces. The resultant is planarized by chemical mechanical polishing essentially to level off the contact portions. Then with a reverse gate lithography step, this dielectric fill and any remaining sidewall oxide is removed from the spaces between the contact portions of the individual transistors. This exposes the surfaces of the channels of the individual transistors where the gate dielectric needs to be formed.

Subsequently, as shown in FIG. 5, there is formed a gate dielectric 32 over the exposed surface of the p-well 18. Gate dielectric 32 is a layer of silicon oxide grown by heating the body 10 (which includes well 18) in a wet atmosphere in the usual fashion.

Typically, in the course of the processing, the doped polysilicon layer 22 experiences sufficient heating, such as during the growth of the gate oxide, to cause donors to diffuse out thereof into the underlying silicon of well 18 to form the n-type conductivity source and drain regions 40 and 42. However, as previously mentioned, by using a multilayer stack for the doped polysilicon layer, such diffusion can be kept to an insignificant level until the diffusion is desired.

Since the diffusion in the well 18 tends to be omnidirectional, some donors will be diffused laterally to extend the n-type regions 40 and 42 under the sidewall spacers 30a and 30b, respectively, there to form more lightly doped regions 40a and 40b, respectively. Thus there is formed the lightly doped drain extension geometry (LDD) that is known to be desirable to make the drain junction more resistant to the undesirable voltage breakdown that can occur there when the electric field at the junction becomes excessive.

Then doped polysilicon is deposited over the entire surface and then planarized to fill the space over the gate layer dielectric 32, as is also shown in FIG. 5, and to form the fill 44 that serves both as the gate and the gate contact of the transistor. For a transistor it is of course desirable to keep the gate fill 44 electrically isolated from both the source and drain contacts. However, if a diode is to be formed, it is the practice to short the drain contact to the gate contact.

It is to be appreciated that the device and process described have the advantage that the gate can be closely aligned between the source and drain contacts, which should make for a compact structure permitting high device density. Moreover, the source and drain contacts areas are the overlaps of the polysilicon layer 22 with the active surface region and should be relatively easy to provide, since they are formed early in the processing. Moreover, because they are supported partially on the dielectric-filled trench, they can be relatively large. A further advantage is that transistors of the kind described herein are particularly compatible for use as the support circuitry for DRAMs of the kind using a vertical pass transistor and vertical storage capacitor of the kind described in a copending application Serial No. , titled MEMORY CELL THAT INCLUDES A VERTICAL TRANSISTOR AND A TRENCH CAPACITOR (attorney docket number 96 P 7596 US), which is being filed concurrently with the present application and herein incorporated by reference for all purposes.

It is to be recognized that it is not necessary to define the active surface region laterally by means of a dielectric filled trench, as described in an illustrative embodiment. Alternatively, the active surface region can be defined in known fashion either by a thick field oxide or by a channel stop. In some cases (e.g., for very high density packing) it may be desirable to confine the source and drain contacts to extend only over the active region.

Additionally, with appropriate changes in the processing the source and drain contact portions need not be multilayers as described, but may be single layers of appropriate material to provide dopants to the underlying semiconductor body to form source and drain regions therein. Additionally, it is not necessary to utilize wells to define the vertical extent of the active surface region.

Referring now to FIG. 6, there is shown a cross-sectional view of a depletion-mode transistor in accordance with an embodiment of the present invention. It will be convenient to use for the reference numerals of FIG. 6, the same reference numerals increased by 100 that were used for FIG. 5 for corresponding features of the embodiments. For example p-well 18 shown in FIG. 5 is shown as p-well 118 in FIG. 6.

As is well known, the main difference between the structures of depletion mode and enhancement-mode transistors is the inclusion in the depletion-mode transistor of a thin layer that is of the same conductivity type as the drain and source and that extends along the surface between the source and drain regions adjacent to the gate dielectric. Accordingly, the embodiment shown in FIG. 6 includes adjacent the gate dielectric 132 a n-type layer 48 that extends between n-type source 140 and n-type drain 142. This layer 48 generally will be of sufficiently high resistivity that it can be depleted and so be made essentially an insulator by the application of an appropriate voltage to the gate to turn off current flow in the layer 48.

It will be apparent that the transistor of FIG. 6 can be made with only minor changes in the process described for the manufacture of an enhancement mode transistor of the kind shown in FIG. 1-5. Essentially the principal difference is to modify the well implantation step to form the channel layer 48.

It is to be appreciated that the specific embodiment described is merely illustrative of the general principles of the invention and that various modifications can be made without departing from the scope of the invention. It should be appreciated that the device illustrated is a symmetrical device and that the roles of the regions 40 and 42 can be reversed by the polarity of the voltage applied therebetween. It also should be appreciated that the diffusion of dopants out of the source and drain regions can be formed at any stage of the process once the conductive layer has been divided to form the two element contact portions. The scope of the invention should therefore be determined not with reference to the above description but with reference to the appended claims along with their full scope of equivalents.

## Claims

1. A process for making a field effect transistor comprising the steps of:
providing a semiconductor body that comprises an active surface region in which the transistor is to be formed;
depositing on a top surface of the active surface region a doped contact layer that can serve as a conductive contact to the active surface region and that includes dopants that can be diffused out to form source and drain regions in the active surface layer;
removing an intermediate portion of the layer so as to form two separate source and drain contact portions that are spaced apart on the top surface of the active surface region by a distance suitable for a length of the channel of the transistor;
providing dielectric spacers at least on the sidewall edges facing one another of the source and drain contact portions;
forming a gate dielectric layer on the surface portion of the active surface region between the source and drain contact portions and their sidewall spacers;
forming a gate over the gate dielectric layer; and
diffusing dopants from the contact portions into the body for forming source and drain regions in the active surface region under the source and drain contact portions and their sidewall spacers.

2. The process of claim 1 in which the semiconductor body includes a dielectric-filled trench for defining laterally the active surface region of the semiconductor body.

3. The process of claim 2 in which the doped conductive layer is deposited also to overlap portions of the dielectric-filled trench so that each contact portion lies over both a portion of the active surface region and a portion of the dielectric-filled trench.

4. The process of claim 3 further comprising a step of forming a well of the one conductivity type in the semiconductor body for defining vertically the active surface region.

5. The process of claim 4 in which the well is of the opposite conductivity to that of the source and drain regions formed by the dopants diffused form the source and drain contact regions for providing an enhancement mode transistor.

6. The process of claim 2 further comprising the steps of forming a well of the one conductivity type in the semiconductor body and forming a layer of the opposite conductivity type at a top surface of the well for serving as a channel of the depletion-mode transistor.

7. The process of claim 1 wherein the semiconductor body is silicon and the doped contact layer is a multilayer stack including a layer of polysilicon, an anti-reflection layer, and a layer of refractory metal silicide.

8. A field effect transistor made in accordance with the process of claim 1.

9. A process for making a transistor comprising the steps of:
forming in a monocrystalline silicon body a dielectric- filled trench to define an active surface region of the body;
implanting ions in the active surface area of the body for establishing desired doping characteristics;
forming over the body a polysilicon layer doped with atoms capable of forming source and drain regions at the active surface area;
etching the polysilicon layer to form a central opening for defining the channel of the transistor, leaving separate source and drain contact portions partially supported on the dielectric-filled trench and partially overlapping the active surface region;
forming dielectric spacers on sidewalls of edges of the polysilicon layer portions overlapping the active surface region;
forming a gate dielectric layer over the active surface area between said dielectric spacers;
providing a gate over the gate dielectric layer; and
heating the source and drain contact portions during processing to cause atoms from the doped polysilicon contact portions to diffuse into the silicon body underlying the contact portions and the sidewall spacers so as to form spaced drain and source regions in the body with the source contact portion being in electrical contact with the source region and the drain contact portion being in electrical contact with the drain region.

10. The process of claim 9 in which the ions implanted in the implanting step make the implanted surface area region of a conductivity type opposite that of the diffused source and drain regions for forming an enhancement-mode transistor.

11. The process of claim 9 in which the implanting step forms in the body a well of the conductivity type opposite that of the diffused source and drain and form a surface layer adjacent the gate dielectric layer that is of the same conductivity type as that of the source and drain regions for forming a depletion mode transistor.

12. A field effect transistor having drain and source regions, a channel, a gate and a gate dielectric, and separate electrical contacts coupled to the drain, source and gate comprising:
a silicon body;
a dielectrical-filled trench within the body and defining an active region of the body;
the source and the drain regions being of the like conductivity type and spaced apart in the active region of the body for defining the channel of the transistor;
the gate dielectric layer being located over the channel;
the electrical contacts coupled to the drain and source regions each being doped polysilicon, and being supported on the dielectric-filled trench such that each partially overlies the active region for contacting the source and the drain regions, respectively;
sidewall spacers on the edges of the electrical contacts that overlie the active region of the body;
the drain and source regions each extending in the active region from a sidewall of the dielectric-filled trench under the respective electrical contacts essentially to an edge of the respective sidewall spacer; and
the gate contact being in contact with the gate dielectric layer and being electrically isolated from the drain and source contacts by the sidewall spacers.
